# EUROPEAN PATENT APPLICATION

(11) **EP 3 940 915 A1**
(43) Date of publication of application: **19.01.2022**
(21) Application number: 21161492.0
(22) Date of filing: 09.03.2021
(51) Int. Cl.: H02J 7/00, H03K 17/12

(54) **BATTERY MANAGEMENT DEVICE AND METHOD THEREOF**

(30) Priority: 15.07.2020 TW 109123866
(71) Applicant: Acer Incorporated, Taipei County 221 (TW)
(72) Inventor: LIN, Jiunn-Jou, 221 New Taipei City (TW)
(74) Representative: 2K Patentanwälte Blasberg Kewitz & Reichel

(57) **Abstract**

A battery management device is provided in the invention. The battery management device includes a discharge circuit, a control circuit, and a switch circuit. The discharge circuit includes a plurality of discharge MOSFETs. The control circuit is coupled to the discharge circuit and when an abnormal discharge occurs, it generates a disable signal. The switch circuit is coupled between the discharge circuit and the control circuit and receives the disable signal from the control circuit. The switch circuit includes a switch MOSFET and the switch MOSFET is coupled to the plurality of discharge MOSFETs. When the switch circuit receives the disable signal, the switch MOSFET is enabled to disable the discharge circuit.

## Description

### CROSS REFERENCE TO RELATED APPLICATIONS

This Application claims priority of TW Patent Application No. 109123866 filed on July 15, 2020, the entirety of which is incorporated by reference herein.

### BACKGROUND OF THE INVENTION

### Field of the Invention

The invention generally relates to battery management technology, and more particularly, to a battery management technology in which, when an abnormal discharge occurs, a switch circuit configured between the discharge circuit and the control circuit is used to accelerate the time taken to disable the discharge MOSFETs of the discharge circuit.

### Description of the Related Art

A battery management system (BMS) is configured in most electronic products to manage the charging and discharging of the battery. In addition, the charge Metal-Oxide-Semiconductor Field-Effect Transistor (MOSFET) and discharge MOSFET will be configured in the BMS to control the starting and stopping of the charging and discharging of the battery.

When an abnormal discharge occurs, the BMS may disable the discharge MOSFET to stop the discharging of the battery. However, when the current is larger, the BMS may disable the discharge MOSFET too late, as a result, the discharge MOSFET may be burned. In addition, when a plurality of discharge MOSFETs are connected in series, because the time offset of disabling each discharge MOSFET, a big current may flow through a single discharge MOSFET, as a result, the discharge MOSFET will be burned.

Therefore, how to disable each discharge MOSFET immediately when an abnormal discharge occurs is a subject that is worthy of discussion.

### BRIEF SUMMARY OF THE INVENTION

A battery management device and method are provided to overcome the problems mentioned above.

An embodiment of the invention provides a battery management device. The battery management device comprises a discharge circuit, a control circuit, and a switch circuit. The discharge circuit comprises a plurality of discharge MOSFETs. The control circuit is coupled to the discharge circuit and when an abnormal discharge occurs, it generates a disable signal. The switch circuit is coupled between the discharge circuit and the control circuit and receives the disable signal from the control circuit. The switch circuit comprises a switch MOSFET and the switch MOSFET is coupled to the plurality of discharge MOSFETs. When the switch circuit receives the disable signal, the switch MOSFET is enabled to disable the discharge circuit.

According to an embodiment of the invention, the discharge MOSFETs are N-MOSFETs and the switch MOSFET is a P-MOSFET.

According to an embodiment of the invention, the source of the switch MOSFET is coupled to the gates of the discharge MOSFETs and the drain of the switch MOSFET is coupled to the sources of the discharge MOSFETs.

According to an embodiment of the invention, the switch MOSFET coupled to a control pin for the discharge MOSFET of the control circuit to receive the disable signal.

According to an embodiment of the invention, the battery management device comprises a diode. The diode is coupled to the source of the switch MOSFET and the control pin for the discharge MOSFET.

An embodiment of the invention provides a battery management method. The battery management method is applied to a battery management device. The battery management method comprises the steps of using a control circuit of the battery management device to detect whether an abnormal discharge occurs; using the control circuit to generate a disable signal when an abnormal discharge occurs; using a switch circuit of the battery management device to receive the disable signal from the control signal, wherein the switch circuit comprises a switch MOSFET; and after the switch circuit receives the disable signal, enabling the switch MOSFET to disable the discharge circuit of the battery management device, wherein the discharge circuit comprises a plurality of discharge MOSFETs and the switch MOSFET is coupled to the plurality of discharge MOSFETs.

Other aspects and features of the invention will become apparent to those with ordinary skill in the art upon review of the following descriptions of specific embodiments of intravenous infusion battery management device and method.

### BRIEF DESCRIPTION OF THE DRAWINGS

The invention will become more fully understood by referring to the following detailed description with reference to the accompanying drawings, wherein:
FIG. 1 is a block diagram of a battery management device 100 according to an embodiment of the invention;
FIG. 2 is a circuit diagram of the discharge circuit 120 and the switch circuit 130 according to an embodiment of the invention; and
FIG. 3 is a flow chart illustrating a battery management method according to an embodiment of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

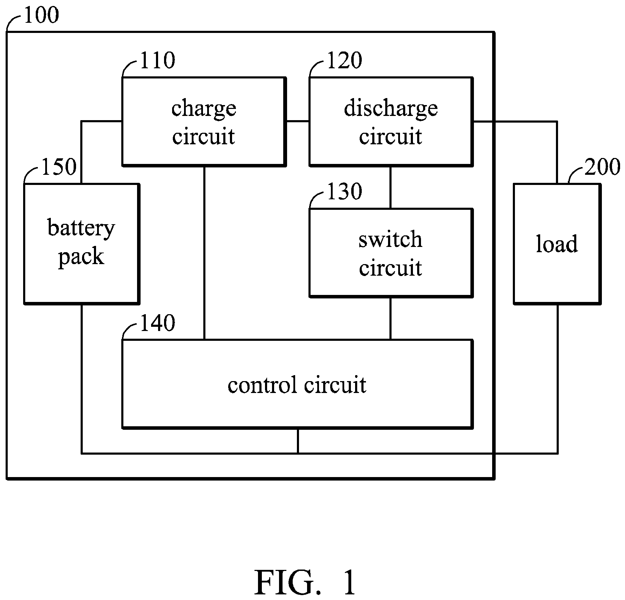

FIG. 1 is a block diagram of a battery management device 100 according to an embodiment of the invention. As shown in FIG. 1, the battery management device 100 may comprise a charge circuit 110, a discharge circuit 120, a switch circuit 130, a control circuit 140 and a battery pack 150. It should be noted that FIG. 1 presents a simplified block diagram in which only the elements relevant to the invention are shown. However, the invention should not be limited to what is shown in FIG. 1. The battery management device 100 may also comprise other elements. In addition, as shown in FIG. 1, the battery management device 100 may connect to a load 200 to provide power to the load 200.

According to the embodiments of the invention, the battery management device 100 is designed based on the high-side N-Metal-Oxide-Semiconductor Field-Effect Transistor (N-MOSFET) method.

According to the embodiments of the invention, the charge circuit 110 may comprise a plurality of N-MOSFETs. When the battery pack 150 needs to be charged (i.e. the battery management device 100 is in a charge state), the charge circuit will be enabled to charge the battery pack 150. According to the embodiments of the invention, the charge circuit 110 may be coupled to the control pin C FET (not shown in figures) for the charge MOSFET and the source detection pin CFS (not shown in figures) for the charge MOSFET of the control circuit 140.

According to the embodiments of the invention, the discharge circuit 120 may comprise a plurality of N-MOSFETs. When the battery pack 150 is used to provide power to the load 200 (i.e. the battery management device 100 is in a charge state), the discharge circuit 120 will be enabled. According to the embodiments of the invention, the discharge circuit 120 may be coupled to the source detection pin (not shown in figures) for the discharge MOSFET of the control circuit 140.

According to the embodiments of the invention, the switch circuit 130 may comprise a P-MOSFET and a diode. According to the embodiments of the invention, the P-MOSFET may be coupled to the control pin D FET for the discharge MOSFET of the control circuit 140.

According to the embodiments of the invention, the control circuit 140 may be an analog front end (AFE) circuit. The control circuit 140 may be coupled to a microcontroller (MCU) (not shown in figures) to receive the commands from the MCU. According to the embodiments of the invention, the control circuit 140 may be configured to detect whether the current voltage is higher than or lower than a voltage range of the battery pack 150, detect the charge current and the discharge current, and detect the temperature of the battery pack 150, but the invention should not be limited thereto. In addition, according to the embodiments of the invention, the control circuit 140 may enable or disable the charge circuit 110 and discharge circuit 120 according the detection results.

According to the embodiments of the invention, the battery pack 150 may comprise a plurality of battery cells.

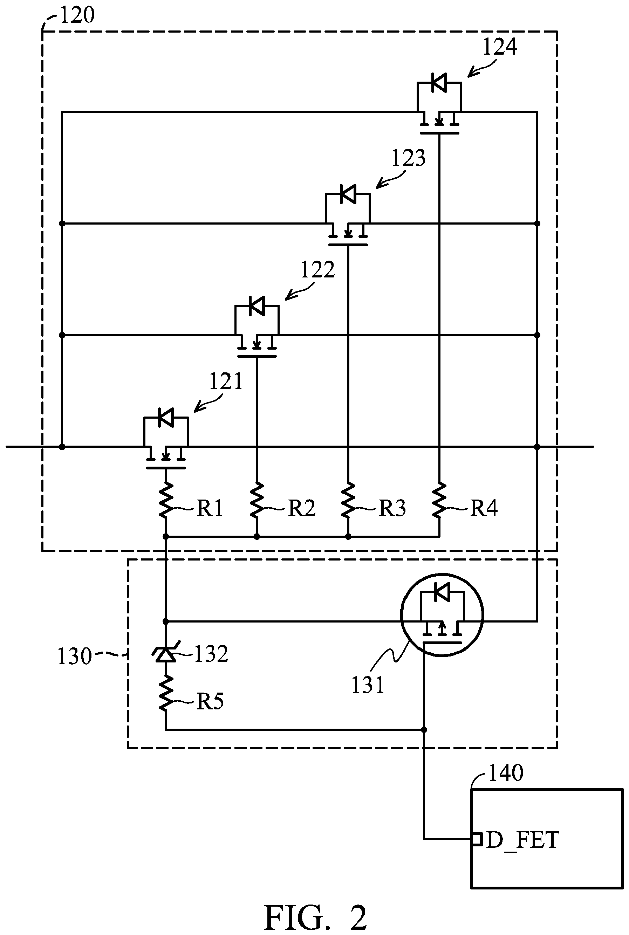

FIG. 2 is a circuit diagram of the discharge circuit 120 and the switch circuit 130 according to an embodiment of the invention. As shown in FIG. 2, the discharge circuit 120 may comprise a first N-MOSFET 121, a second N-MOSFET 122, a third N-MOSFET 123 and a fourth N-MOSFET 124. The first N-MOSFET 121, the second N-MOSFET 122, the third N-MOSFET 123 and the fourth N-MOSFET 124 are connected in series. It should be noted that in the circuit diagram of FIG. 2, the discharge circuit 120 comprises four N-MOSFETs, but the invention should not be limited thereto. The discharge circuit 120 may comprise other numbers of N-MOSFETs. In addition, as shown in FIG. 2, the switch circuit 130 may comprise a P-MOSFET 131 and a diode 132.

As shown in FIG. 2, the gates of the first N-MOSFET 121, the second N-MOSFET 122, the third N-MOSFET 123 and the fourth N-MOSFET 124 may be coupled to the source of the P-MOSFET 131 through the first resistor R1, the second resistor R2, a third resistor R3 and a fourth resistor R4 respectively.

The sources of the first N-MOSFET 121, the second N-MOSFET 122, the third N-MOSFET 123 and the fourth N-MOSFET 124 may be coupled to the drain of the P-MOSFET 131.

The drains of the first N-MOSFET 121, the second N-MOSFET 122, the third N-MOSFET 123 and the fourth N-MOSFET 124 may be coupled to the discharge circuit 110.

The gate of the P-MOSFET 131 may be coupled to the control pin D_FET for the discharge MOSFET of the control circuit 140. One end of the diode 132 may be coupled to the source of the P-MOSFET 131, and the other end of the diode 132 may be coupled to the gate of the P-MOSFET 131 through the fifth resistor R5.

According to an embodiment of the invention, when the battery management device 100 is in discharge state, the control circuit 140 may detect whether the abnormal discharge occurs. According to the embodiments of the invention, the abnormal discharge may be the discharge current is too large, the temperature of the battery pack 150 is too high or the current voltage is higher than the voltage range of the battery pack 150, but the invention should not be limited thereto.

When the control circuit 140 detects the abnormal discharge, the control circuit 140 may output a low level signal (i.e. disable signal) from the control pin D FET for the discharge MOSFET to the P-MOSFET 131 of the switch circuit 130. When the P-MOSFET 131 receives the low level signal, the P-MOSFET 131 will be enabled. After the P-MOSFET 131 is enabled, the gates of first N-MOSFET 121, the second N-MOSFET 122, the third N-MOSFET 123 and the fourth N-MOSFET 124 will be pulled to the same level as the sources of first N-MOSFET 121, the second N-MOSFET 122, the third N-MOSFET 123 and the fourth N-MOSFET 124.

When levels of the gates of first N-MOSFET 121, the second N-MOSFET 122, the third N-MOSFET 123 and the fourth N-MOSFET 124 will be pulled to the same levels as the sources of first N-MOSFET 121, the second N-MOSFET 122, the third N-MOSFET 123 and the fourth N-MOSFET 124.

After the levels of the gates of the first N-MOSFET 121, the second N-MOSFET 122, the third N-MOSFET 123 and the fourth N-MOSFET 124 are pulled to the same levels as the sources of first N-MOSFET 121, the second N-MOSFET 122, the third N-MOSFET 123 and the fourth N-MOSFET 124, it means that the gate-source voltages Vgs of the first N-MOSFET 121, the second N-MOSFET 122, the third N-MOSFET 123 and the fourth N-MOSFET 124 will be changed to 0.

After the gate-source voltages Vgs of the first N-MOSFET 121, the second N-MOSFET 122, the third N-MOSFET 123 and the fourth N-MOSFET 124 are changed to 0, it means that the gate-source voltage Vgs will be smaller than the threshold voltage Vt. When the gate-source voltages Vgs of the first N-MOSFET 121, the second N-MOSFET 122, the third N-MOSFET 123 and the fourth N-MOSFET 124 are smaller than the threshold voltage Vt, the first N-MOSFET 121, the second N-MOSFET 122, the third N-MOSFET 123 and the fourth N-MOSFET 124 will be disabled to make the power management device 100 stop outputting the power to the load 200.

According to an embodiment of the invention, the diode 132 of the switch circuit 130 is configured to prevent the high voltage returning to the P-MOSFET 131, as a result, the P-MOSFET is disabled.

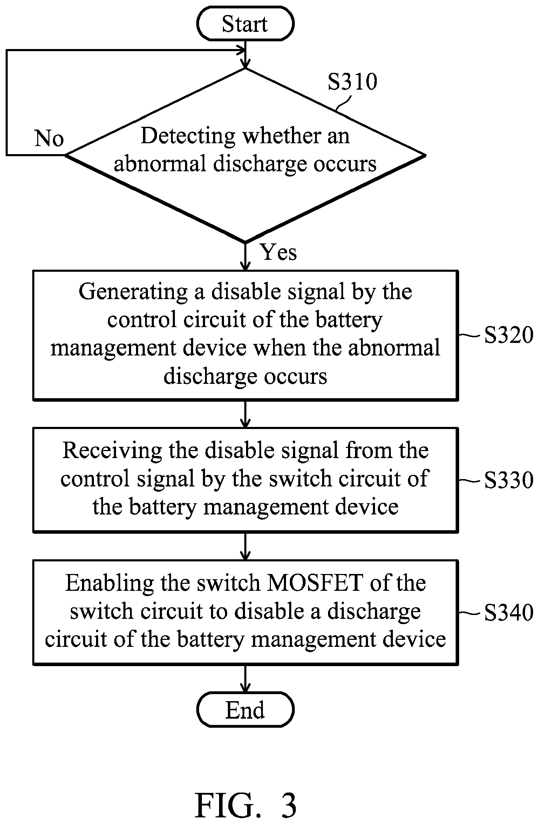

FIG. 3 is a flow chart illustrating a battery management method according to an embodiment of the invention. The battery management method can be applied to the battery management device 100. As shown in FIG. 3, in step S310, a control circuit of the battery management device 100 may detect whether the abnormal discharge occurs.

In step S320, when an abnormal discharge occurs, the control circuit of the battery management device 100 is configured to generate a disable signal (e.g. a low level signal).

In step S330, a switch circuit of the battery management device 100 receives the disable signal from the control signal. In the embodiment, the switch signal may comprise a switch MOSFET. According to the embodiments of the invention, the switch MOSFET may be a P-MOSFET.

In step S340, after the switch circuit of the battery management device 100 receives the disable signal, the switch MOSFET is enabled to disable the discharge circuit of the battery management device 100. In the embodiment, the discharge circuit of the battery management device 100 may comprise a plurality of discharge MOSFETs, and the switch MOSFET of the battery management device 100 is coupled to the discharge MOSFETs. According to the embodiments of the invention, the discharge MOSFET may be the N-MOSFET. When the switch MOSFET is enabled, the discharge MOSFETs will be disabled to disable the discharge circuit.

According to the battery management method, when an abnormal discharge occurs, the switch circuit configured between the discharge circuit and the control circuit can be configured to accelerate the time taken to disable the discharge MOSFETs of the discharge circuit to prevent the burning of the discharge MOSFET.

Use of ordinal terms such as "first", "second", "third", etc., in the disclosure and claims is for description. It does not by itself connote any order or relationship.

The steps of the method described in connection with the aspects disclosed herein may be embodied directly in hardware, in a software module executed by a processor, or in a combination of the two. A software module (e.g., including executable instructions and related data) and other data may reside in a data memory such as RAM memory, flash memory, ROM memory, EPROM memory, EEPROM memory, registers, a hard disk, a removable disk, a CD-ROM, or any other form of computer-readable storage medium known in the art. A sample storage medium may be coupled to a machine such as, for example, a computer/processor (which may be referred to herein, for convenience, as a "processor") such that the processor can read information (e.g., code) from and write information to the storage medium. A sample storage medium may be integral to the processor. The processor and the storage medium may reside in an ASIC. The ASIC may reside in user equipment. Alternatively, the processor and the storage medium may reside as discrete components in user equipment. Moreover, in some aspects any suitable computer-program product may comprise a computer-readable medium comprising codes relating to one or more of the aspects of the disclosure. In some aspects a computer program product may comprise packaging materials.

The above paragraphs describe many aspects. Obviously, the teaching of the invention can be accomplished by many methods, and any specific configurations or functions in the disclosed embodiments only present a representative condition. Those who are skilled in this technology will understand that all of the disclosed aspects in the invention can be applied independently or be incorporated.

While the invention has been described by way of example and in terms of preferred embodiment, it should be understood that the invention is not limited thereto. Those who are skilled in this technology can still make various alterations and modifications without departing from the scope and spirit of this invention. Therefore, the scope of the present invention shall be defined and protected by the following claims and their equivalents.

## Claims

1. A battery management device (100), comprising:
a discharge circuit (120), comprising a plurality of discharge Metal-Oxide-Semiconductor Field-Effect Transistors, MOSFETs, (121-124); and
a control circuit (140), coupled to the discharge circuit and when an abnormal discharge occurs, generating a disable signal; and
a switch circuit (130), coupled between the discharge circuit and the control circuit and receiving the disable signal from the control circuit, wherein the switch circuit comprises a switch MOSFET (131) and the switch MOSFET is coupled to the plurality of discharge MOSFETs,
wherein when the switch circuit receives the disable signal, the switch MOSFET is enabled to disable the discharge circuit.

2. The battery management device of claim 1, wherein the discharge MOSFETs are N-MOSFETs (121-124) and the switch MOSFET is a P-MOSFET (131).

3. The battery management device of claim 2, wherein the source of the switch MOSFET (131) is coupled to the gates of the discharge MOSFETs (121-124) and the drain of the switch MOSFET is coupled to the sources of the discharge MOSFETs.

4. The battery management device of claim 2 or 3, wherein the gate of the switch MOSFET (131) is coupled to a control pin for the discharge MOSFET(121-124) of the control circuit to receive the disable signal.

5. The battery management device of claim 4, further comprising:
a diode (132), coupled to the source of the switch MOSFET and the control pin for the discharge MOSFET.

6. A battery management method applied to a battery management device (100), comprising:
detecting, by a control circuit (140) of the battery management device, whether an abnormal discharge occurs (S310);
generating, by the control circuit (140), a disable signal when the abnormal discharge occurs (S320);
receiving, by a switch circuit (130)of the battery management device, the disable signal from the control signal, wherein the switch circuit comprises a switch Metal-Oxide-Semiconductor Field-Effect Transistor, MOSFET, (S330); and
after the switch circuit receives the disable signal, enabling the switch MOSFET (131) to disable a discharge circuit of the battery management device (S340),
wherein the discharge circuit comprises a plurality of discharge MOSFETs (121-124) and the switch MOSFET (131) is coupled to the plurality of discharge MOSFETs.

7. The battery management method of claim 6, wherein the discharge MOSFETs are N-MOSFETs (121-124) and the switch MOSFET is a P-MOSFET (131).

8. The battery management method of claim 7, wherein the source of the switch MOSFET (131) is coupled to the gates of the discharge MOSFETs (121-124) and the drain of the switch MOSFET is coupled to the sources of the discharge MOSFETs.

9. The battery management method of claim 7 or 8, wherein the gate of the switch MOSFET (131) is coupled to a control pin for the discharge MOSFET (121-124) of the control circuit to receive the disable signal.

10. The battery management method of claim 9, wherein a diode (132) of the battery management is coupled to the source of the switch MOSFET and the control pin for the discharge MOSFET.
